# EUROPEAN PATENT APPLICATION

(11) **EP 4 715 955 A1**
(43) Date of publication of application: **25.03.2026**
(21) Application number: 25776001.7
(22) Date of filing: 05.02.2025
(51) Int. Cl.: H01M 10/42, H01M 10/48, H01M 50/287, G01R 31/396

(54) **BATTERY SYSTEM WITH SAME WIRELESS COMMUNICATION PERFORMANCE**

(30) Priority: 29.03.2024 KR 20240043438
(71) Applicant: LG Energy Solution, Ltd., Seoul 07335 (KR)
(72) Inventor: HA, Jeongwan, Daejeon 34122 (KR); CHOI, Wonjae, Daejeon 34122 (KR); LEE, Yongseok, Daejeon 34122 (KR)
(74) Representative: Plasseraud IP
(86) International application number: PCT/KR2025/099265
(87) International publication number: WO 2025/206915

(57) **Abstract**

The present disclosure relates to a battery system with identical wireless communication performance, and the battery system for performing wireless communication using a frequency hopping method according to an embodiment includes: battery modules; a single antenna; slave BMSs connected to the battery modules, generating battery information by sensing states of the battery modules, and providing sensing signals including the battery information to the single antenna; and a master BMS connected to an antenna, receiving the sensing signals transmitted through the single antenna through the antenna, obtaining the battery information according to the sensing signals, generating control signals for controlling the battery modules by using the obtained battery information, and transmitting the control signals to the single antenna through the antenna.

## Description

### [Technical Field]

Cross-Reference to Related Application(s)

This application claims priority to and the benefit of Korean Patent Application no. 10-2024-0043438, filed on March 29, 2024, with the Korean Intellectual Property Office, the entire contents of which are incorporated herein by reference.

The present invention relates to a battery system with same wireless communication performance.

### [Background Art]

In a 1:many wireless communication environment between a master BMS and slave BMSs using a frequency hopping method, each node of the slave BMSs has an individual antenna connected to it, and each node performs wireless communication with the master BMS using an individual antenna. The distances between the nodes of slave BMSs and the master BMS inside the battery pack become different, resulting in wireless communication performance deviation, which causes the wireless communication performances of the nodes to differ.

The nodes of slave BMSs are affected by different structures depending on installation positions. Accordingly, the resonant frequency of each antenna connected to each node may be changed by the structure at the installation position of each node. Accordingly, wireless performance deviation additionally occurs due to changes in the resonant frequency in the frequency hopping channel allocated to each node according to frequency hopping.

### [Disclosure]

The present disclosure attempts to provide a battery system having same wireless communication performance between slave BMSs and a master BMS by integrating antennae of the slave BMSs.

An embodiment of the present disclosure provides a battery system for performing wireless communication using a frequency hopping method including: battery modules; a single antenna; slave BMSs connected to the battery modules, generating battery information by sensing states of the battery modules, and providing sensing signals including the battery information to the single antenna; and a master BMS connected to an antenna, receiving the sensing signals transmitted through the single antenna through the antenna, obtaining the battery information according to the sensing signals, generating control signals for controlling the battery modules by using the obtained battery information, and transmitting the control signals to the single antenna through the antenna.

The battery information may include an information identifier indicating the slave BMS having generated specific battery information from among the slave BMSs.

The control signals may include operation information for controlling an operation of at least one of the battery modules.

The operation information may include an instruction identifier for indicating a specific slave BMS from among the slave BMSs.

The master BMS may wirelessly communicate with the slave BMSs by a frequency hopping method using an industrial scientific medical (ISM) bandwidth as a frequency bandwidth.

The master BMS may designate a specific frequency bandwidth, may select hopping channels in the specific frequency bandwidth, and may generate an arbitrary pattern using the selected hopping channel to perform wireless communication.

The battery system may include a substrate on which the slave BMSs and the single antenna are arranged, and a housing into which the battery modules and the substrate are received and in which the master BMS is arranged.

The slave BMSs may include an integrated distributor for receiving the sensing signals, integrating the received sensing signals, and transmitting the integrated sensing signals through the single antenna, and connectors for connecting nodes of the slave BMSs to the integrated distributor using a wire.

The integrated distributor may recognize the instruction identifier of the control signal received from the master BMS and may transmit the control signal to a specific slave BMS from among the slave BMSs.

The integrated distributor may transmit the control signal received from the master BMS to the slave BMSs through the connectors.

First ends of the connectors may be connected to nodes of the slave BMSs, and second ends thereof may be connected to the integrated distributor.

The connectors may have the same length.

The battery system may include a substrate on which the slave BMSs, the single antenna, the integrated distributor, and the connectors are arranged, and a housing into which the battery modules and the substrate are received and in which the master BMS is arranged.

According to the embodiments, the deviation between the performances of wireless communication due to the distance difference between the slave BMSs and the master BMSs or the structure influence may be improved, thereby ensuring stable and identical wireless communication performance.

The effects of the present disclosure are not limited to those mentioned above, and other effects not mentioned will be apparent to those skilled in the art from the following description.

### [Description of the Drawings]

FIG. 1 shows a block diagram of a battery system according to an embodiment.
FIG. 2 shows a block diagram of a battery system according to another embodiment.
FIG. 3 shows an example of a battery system according to an embodiment.
FIG. 4 shows an example of a battery system according to another embodiment.
FIG. 5 shows a battery system in which respective slave BMSs are connected to each antenna according to a comparative example.
FIG. 6 shows an example of a battery system according to another embodiment.
FIG. 7 shows an implemented example of a battery system according to another embodiment.
FIG. 8 shows that respective components of an implemented example of FIG. 7 are separated.
FIG. 9 shows an implemented cross-sectional example of FIG. 7 with respect to a line A-A'.

### [Mode for Invention]

In describing embodiments of the present specification, when it is determined that a detailed description of the well-known art associated with the present disclosure may obscure the gist of the present disclosure, it will be omitted. The accompanying drawings are provided only in order to allow embodiments disclosed in the present specification to be easily understood and are not to be interpreted as limiting the spirit disclosed in the present specification, and it is to be understood that the present disclosure includes all modifications, equivalents, and substitutions without departing from the scope and spirit of the present disclosure.

Terms including ordinal numbers such as first, second, and the like, will be used only to describe various components, and are not interpreted as limiting these components. The terms are only used to differentiate one component from other components.

It is to be understood that when one component is referred to as being "connected" or "coupled" to another component, it may be connected or coupled directly to another component or be connected or coupled to another component with the other component intervening therebetween. On the other hand, it is to be understood that when one component is referred to as being "connected or coupled directly" to another component, it may be connected to or coupled to another component without the other component intervening therebetween.

It will be further understood that terms "comprises" or "have" used in the present specification specify the presence of stated features, numerals, steps, operations, components, parts, or a combination thereof, but do not preclude the presence or addition of one or more other features, numerals, steps, operations, components, parts, or a combination thereof.

The present disclosure will now be described in detail with reference to accompanying drawings.

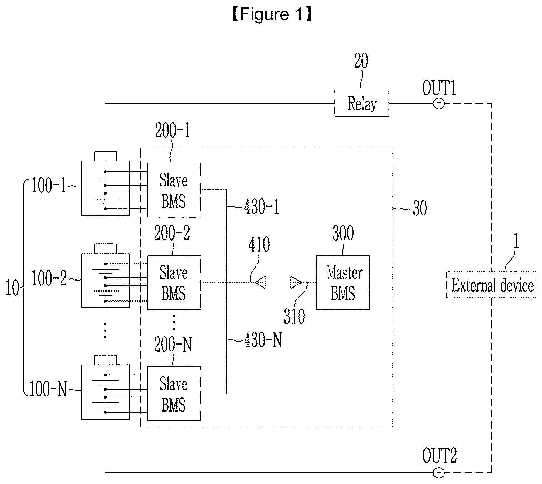

FIG. 1 shows a block diagram of a battery system according to an embodiment.

Referring to FIG. 1, the battery system 2 includes a battery 10, a relay 20, and a battery management system (BMS) 30.

The battery 10 is connected between two output terminals OUT1 and OUT2 of the battery system 2. The relay 20 may be connected between a positive electrode of the battery system 2 and the first output terminal OUT1, and a current sensor (not shown) may be connected between a negative electrode of the battery system and the second output terminal OUT2. Potential of the positive electrode is higher than potential of the negative electrode.

The battery 10 may include battery modules 100-1,100-2 to 100-N connected in series and in parallel. The respective battery modules 100-1,100-2 to 100-N may include battery cells electrically connected in series and in parallel. In an embodiment, the battery cells may be rechargeable batteries. The battery modules 100-1,100-2 to 100-N are shown to be connected in series, and the respective battery modules 100-1,100-2 to 100-N are shown to include battery cells connected in series, which are not limited thereto, and the battery modules 100-1,100-2 to 100-N and the battery cells may be configured to be connected in series and/or in parallel.

The relay 20 may function as a switch for controlling the electrical connection between the battery system 2 and an external device 1. When the relay 20 is turned to ON, the battery system 2 may be electrically connected to the external device 1 to be charged or discharged. When the relay 20 is turned to OFF, the battery system 2 may be electrically disconnected from the external device 1. The external device 1 may be a charger in a charge cycle during which electric power voltage is supplied to the battery 10 to charge the same, and it may be a load in a discharge cycle during which the battery 10 discharges electric power voltage to the external device 1.

The BMS 30 may include slave BMSs 200-1, 200-2 to 200-N and a master BMS 300. The BMS 30 may include at least one slave BMS 200-1 to N and a master BMS 300.

The slave BMSs 200-1, 200-2 to 200-N and the master BMS 300 transmit/receive signals by a wireless communication method. For example, the respective slave BMSs 200-1, 200-2 to 200-N may transmit sensing signals generated by measuring states of the battery modules 100-1,100-2 to 100-N to the master BMS 300. The master BMS 300 may generate control signals based on the sensing signal, and may transmit the control signals to the slave BMSs 200-1, 200-2 to 200-N.

According to an embodiment, the slave BMSs 200-1, 200-2 to 200-N communicate with the master BMS 300 by a wireless communication method following a frequency hopping method. The frequency hopping method is a communication method that divides a specific frequency bandwidth into frequency bandwidths of a certain size, places channels with different frequency bandwidths, and transmits divided data while changing the channel through which the signal is transmitted. Signal interference between the battery system 2 and another communication device using the same frequency bandwidth as the battery system 2 may be reduced by the frequency hopping method, thereby preventing deterioration of communication quality.

According to an embodiment, frequency bandwidths used in the frequency hopping method may include an industrial scientific medical (ISM) band. The ISM bandwidth represents a frequency bandwidth allocated for industrial, scientific, and medical use and may be used without separate use licenses. Worldwide, common ISM bandwidths are established at 900 MHz, 2.4 GHZ, and 5.7 GHZ bands. For example, Bluetooth and Zigbee uses the frequency bandwidth of 2.4GHZ, and Wi-Fi uses the two frequency bandwidths 2.4GHZ and 5GHZ.

The slave BMSs 200-1, 200-2 to 200-N may be connected to the battery modules 100-1,100-2 to 100-N, and may sense the states of the battery modules 100-1,100-2 to 100-N to generate battery information.

The battery information represents information generated by sensing the state of a specific battery module by a specific slave BMS. According to an embodiment, the battery information may include information (e.g., cell current, cell voltage, cell temperature, etc.) measured by the slave BMS and information (e.g., state of Charge (SOC) and state of health (SOH)) estimated by the slave BMS.

According to an embodiment, the battery information may include an information identifier indicating the slave BMS having generated corresponding battery information from among the slave BMSs 200-1, 200-2 to 200-N.

The slave BMSs 200-1, 200-2 to 200-N may generate sensing signals including battery information, and may transmit the generated sensing signals to the master BMS 300 through a single antenna 410. The single antenna 410 may transmit the sensing signals generated by the slave BMSs 200-1, 200-2 to 200-N to the master BMS 300 simultaneously or with time intervals.

That is, the battery system may wirelessly communicate with the master BMS 300 through the single antenna 410 connected to nodes of the slave BMSs 200-1, 200-2 to 200-N in the case of many:1 wireless communication between the slave BMSs 200-1, 200-2 to 200-N and the master BMS 300.

The master BMS 300 may receive the sensing signals from the slave BMSs 200-1, 200-2 to 200-N to obtain battery information on the battery modules 100-1,100-2 to 100-N, and may generate control signals based on the obtained battery information. The generated control signals may be transmitted through the antenna 310 connected to the node of the master BMS 300.

The control signals may represent signals for controlling operations of the battery modules 100-1,100-2 to 100-N, and may include operation information on the battery modules 100-1,100-2 to 100-N. According to an embodiment, the control signals may respectively include at least one or more operation information.

The operation information may control the operation of a specific battery module from among the battery modules 100-1,100-2 to 100-N. According to an embodiment, the operation information may include instructions for instructing the SOC, SOH, power control, cell balancing, malfunction diagnosis, and cooling control of the battery modules 100-1,100-2 to 100-N and information for performing corresponding operations.

According to an embodiment, the operation information may include instruction identifiers. The instruction identifier indicates that the corresponding operation information is operation information for a predetermined slave BMS from among the slave BMSs 200-1, 200-2 to 200-N.

According to an embodiment, the master BMS 300 may generate a frequency hopping sequence, and may wirelessly communicate with the slave BMSs 200-1, 200-2 to 200-N according to the frequency hopping sequence.

For example, the master BMS 300 may designate the ISM bandwidth as the frequency bandwidth used in the wireless communication, may select hopping channels to be used in the frequency hopping method from among the channels CH_1 to CH_N existing in the ISM bandwidth, and may generate a frequency hopping sequence using the selected hopping channels. The hopping sequence represents a random pattern formed using the selected hopping channel.

For example, when the ISM bandwidth is divided into a first channel CH_1 to a tenth channel CH_10, the master BMS 300 may select the first channel CH_1, the third channel CH_3, and the eighth channel CH_8 as hopping channels. The master BMS 300 may use the selected hopping channels, that is, the first channel CH_1, the third channel CH_3, and the eighth channel CH_8, may divide data and may transmit the same while changing the channels in order of the first channel CH_1, the third channel CH_3, the first channel CH_1, the eighth channel CH_8, and the third channel CH_3. The order of channels used in transmitting data forms an arbitrary pattern which is referred to as the hopping sequence. That is, the master BMS 300 may reduce or solve the mutual interference of signals by changing the channels, and dividing the data and transmitting the same according to the frequency hopping method.

The control signal received through the single antenna 410 may be provided to the slave BMSs 200-1, 200-2 to 200-N, and the respective slave BMSs 200-1, 200-2 to 200-N may determine whether to be operated according to operation information with respect to the instruction identifier of the control signal. The slave BMS indicated by the instruction identifier from among the slave BMSs 200-1, 200-2 to 200-N may be operated according to the operation information of the control signal.

According to an embodiment, the battery system 2 may include a substrate and a housing for arranging and receiving components. For example, the slave BMSs 200-1, 200-2 to 200-N and the single antenna 410 may be arranged on a substrate (not shown in the drawing) made of an insulator. The battery modules 100-1,100-2 to 100-N may be received into an inside of the housing (not shown in the drawing) together with the substrate, and the master BMS 300 may be arranged on a one surface of the housing. The single antenna 410 may be implemented in a chip form, may be arranged on a portion of the substrate, and may be connected to the slave BMSs 200-1 to 200-6 on the substrate.

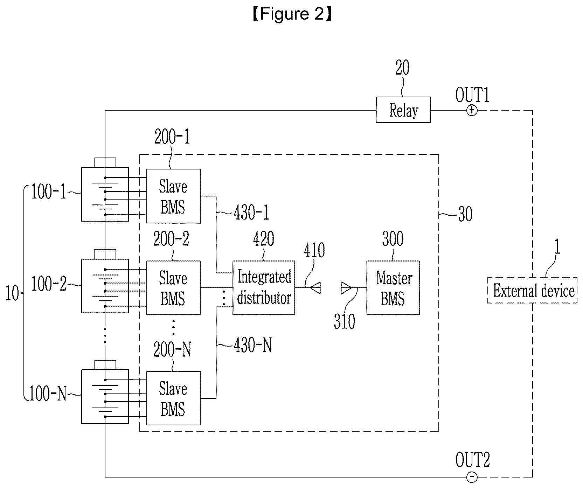

FIG. 2 shows a block diagram of a battery system according to another embodiment.

Referring to FIG. 2, the battery system may further include connectors 430-1, 430-2 to 430-N and an integrated distributor 420. The single antenna 410 is not directly connected to the nodes of the slave BMSs 200-1, 200-2 to 200-N, and is connected to the slave BMSs 200-1, 200-2 to 200-N through the integrated distributor 420 and the connectors 430-1, 430-2 to 430-N. However, the components shown in FIG. 2 and connection relationships among them are an example, and the present disclosure is not limited thereto.

The connectors 430-1, 430-2 to 430-N may connect the nodes of the slave BMSs 200-1, 200-2 to 200-N to the integrated distributor 420 with wires. First ends of the connectors 430-1, 430-2 to 430-N may be connected to the nodes of the slave BMSs 200-1, 200-2 to 200-N, and second ends of the connectors 430-1, 430-2 to 430-N may be connected to the integrated distributor 420. According to an embodiment, the connectors 430-1, 430-2 to 430-N may have the same length.

As shown in FIG. 2, the slave BMSs 200-1, 200-2 to 200-N and the integrated distributor 420 are arranged on different positions in the battery system 2. The respective lengths of the connectors 430-1, 430-2 to 430-N may be determined by the distance to the integrated distributor 420 from the slave BMSs 200-1, 200-2 to 200-N. That is, the connectors 430-1, 430-2 to 430-N have length differences among the same. Time differences among the times used when the sensing signals generated by the slave BMSs 200-1, 200-2 to 200-N reach the integrated distributor 420 may be generated by the length differences among the connectors 430-1, 430-2 to 430-N.

The time differences may be ignored. However, to solve the time differences, the connectors 430-1, 430-2 to 430-N may be implemented to have the same length. By this, deviation of wireless communication performance between the slave BMSs 200-1, 200-2 to 200-N and the master BMS 300 may be further reduced. When the connectors 430-1, 430-2 to 430-N have the same length, there may be a connector that is folded or rolled up from among the connectors 430-1, 430-2 to 430-N according to the positions where the slave BMSs 200-1, 200-2 to 200-N and the integrated distributor 420 are arranged.

According to an embodiment, the connectors 430-1, 430-2 to 430-N may be a RF coaxial cable. However, types of the connectors 430-1, 430-2 to 430-N are not limited thereto, and any types thereof for connecting the slave BMSs 200-1, 200-2 to 200-N and the integrated distributor 420 may be used.

The integrated distributor 420 may receive sensing signals from the slave BMSs 200-1, 200-2 to 200-N, may integrate the received sensing signals, and may transmit the integrated sensing signals through the single antenna 410. The integrated distributor 420 may recognize the instruction identifier of the control signal received from the master BMS 300 and may transmit the received control signal to a specific slave BMS from among the slave BMSs 200-1, 200-2 to 200-N. When the integrated distributor 420 fails to recognize the instruction identifier, the integrated distributor 420 may transmit the control signal to the slave BMSs 200-1, 200-2 to 200-N through the connectors 430-1, 430-2 to 430-N. According to an embodiment, the integrated distributor 420 may be an N-way splitter. The respective slave BMSs 200-1, 200-2 to 200-N may determine whether to be operated according to operation information according to the instruction identifier of the control signal.

An identifier may be displayed to battery information and operation information included in the sensing signal and the control signal. According to an embodiment, the identifier may show that it is generated by the specific slave BMS from among the slave BMSs 200-1, 200-2 to 200-N or it is transmitted to the specific slave BMS from among the slave BMSs 200-1, 200-2 to 200-N.

When the wireless communication by the frequency hopping method is performed between the master BMS 300 and the slave BMSs 200-1, 200-2 to 200-N, and the sensing signals are combined by the integrated distributor 420, interference among signals is not generated. On the contrary, when the master BMS 300 and the slave BMSs 200-1, 200-2 to 200-N do not perform the wireless communication based on the frequency hopping method, it is needed to control the communication between the master BMS 300 and the slave BMSs 200-1, 200-2 to 200-N, such as to set different frequency bandwidths of the sensing signals or set different times for transmitting the sensing signals so that there may be generated no interference among signals in the integrated distributor 420.

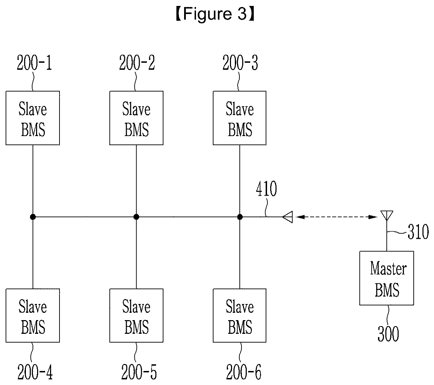

FIG. 3 shows an example of a battery system according to an embodiment.

Referring to FIG. 3, regarding the battery system 2, the nodes of the slave BMSs 200-1, 200-2 to 200-6 are connected to the single antenna 410. That is, the slave BMSs 200-1, 200-2 to 200-6 wirelessly communicate with the master BMS 300 through the single antenna 410. The sensing signals generated by the slave BMSs 200-1, 200-2 to 200-6 may be transmitted to the master BMS 300 at the identical time. Hence, deviation of the wireless communication performance caused by the deviation between the distances between the nodes of the slave BMSs 200-1, 200-2 to 200-6 and the master BMS 300 may be prevented from being generated.

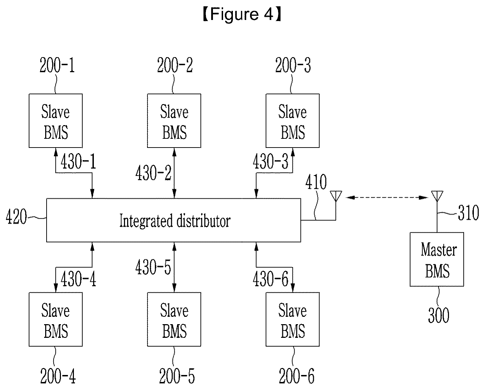

FIG. 4 shows an example of a battery system according to another embodiment.

Referring to FIG. 4, regarding the battery system 2, the nodes of the slave BMSs 200-1, 200-2 to 200-6 are connected to the integrated distributor by the connectors 430-1, 430-2 to 430-6. The slave BMSs 200-1, 200-2 to 200-6 wirelessly communicates with the master BMS 300 through the single antenna 410. Hence, the sensing signals generated by the slave BMSs 200-1, 200-2 to 200-6 are transmitted to the master BMS 300 at the identical time. Hence, deviation of the wireless communication performance caused by the deviation between the distances between the nodes of the slave BMSs 200-1, 200-2 to 200-6 and the master BMS 300 may be prevented from being generated.

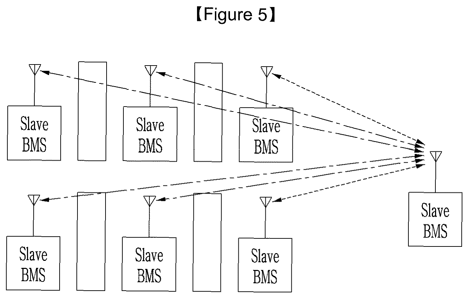

FIG. 5 shows a battery system in which respective slave BMSs are connected to each antenna according to a comparative example.

As shown in FIG. 5, the battery system may have a specific structure between the slave BMSs and the master BMS according to designs. The battery system is influenced by different structures according to the positions where the slave BMSs are installed in the battery system. Hence, resonant frequencies of the antennas connected to the slave BMSs are set to be different from each other. Particularly, when performing wireless communication by the frequency hopping method, irregular wireless performance deviation by different resonant frequencies may be additionally generated for the frequency hopping channels allocated for respective slave BMSs.

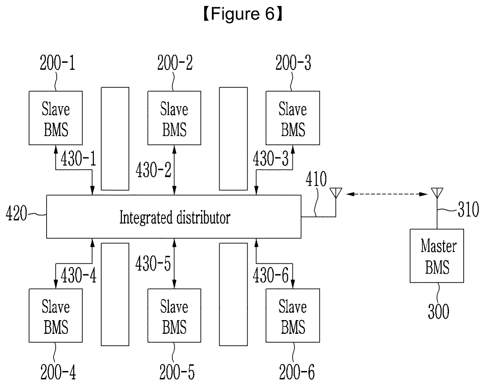

FIG. 6 shows an example of a battery system according to another embodiment.

Referring to FIG. 6, regarding the battery system 2, the slave BMSs 200-1, 200-2 to 200-6 wirelessly communicates with the master BMS 300 through the single antenna 410. Therefore, when the slave BMSs 200-1 and 200-2 to 200-6 are installed on the different positions in the battery system 2, the influence of the structure to the wireless communication between the slave BMSs 200-1, 200-2 to 200-N and the master BMS 300 is the same so no performance deviation of wireless communication according to the influence of the structure is generated.

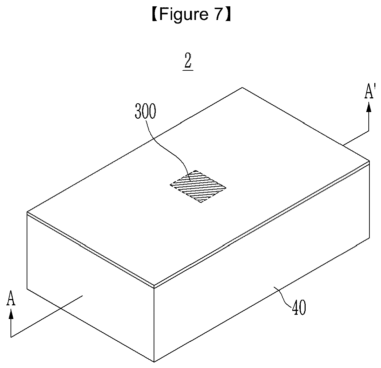

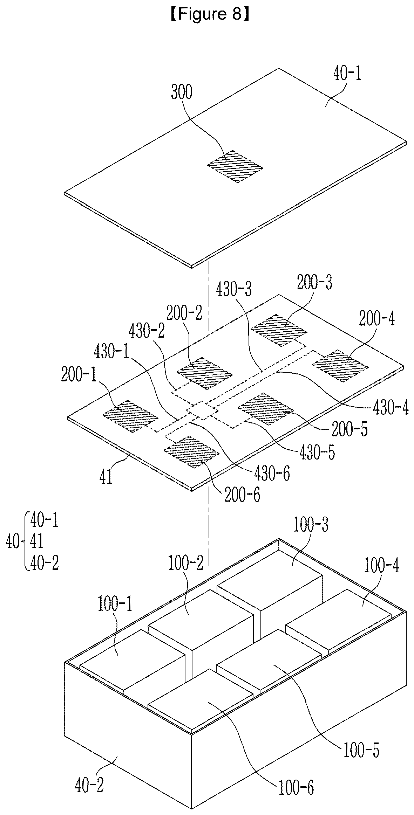

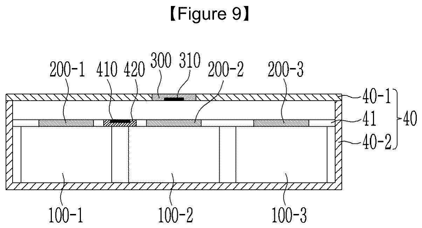

FIG. 7 shows an implemented example of a battery system according to another embodiment, FIG. 8 shows that respective components of an implemented example of FIG. 7 are separated, and FIG. 9 shows an implemented cross-sectional example of FIG. 7 with respect to a line A-A'.

Referring to FIG. 7 to FIG. 9, the battery system 2 may be implemented such that the battery 10, the relay 20, and the battery management system 30 may be received inside the housing 40 or may be arranged in the housing 40.

For example, as shown in FIG. 7 to FIG. 9, the battery system 2 may be implemented such that the master BMS 300 may be arranged on a portion of the housing 40, and the battery modules 100-1 to 100-6 and the slave BMSs 200-1 to 200-6 may be received in the housing 40. The antenna 310 connected to the master BMS 300 may be implemented to be installed in the master BMS 300.

FIG. 7 to FIG.9 shows that six battery modules 100-1 to 100-6 and six slave BMSs 200-1 to 200-6 are received in the housing 40, the number of the battery modules and the slave BMSs is not limited thereto, and it may be changeable if needed.

FIG. 7 shows that the master BMS 300 is installed inside an upper surface of the housing 40, the position of the master BMS 300 in the housing 40 is not limited thereto and it may be changeable if needed. For example, the master BMS 300 may be arranged on an interior surface or an external surface of the housing 40. The master BMS 300 may be arranged on the external surface disposed in a direction facing the single antenna 410 from among the external surfaces included in the housing 40. In another way, the master BMS 300 may be arranged outside the housing 40. In another way, the master BMS 300 may be arranged on an exterior side or an internal side of the housing 40.

The housing 40 may be made of an insulator, and as shown in FIG. 7, it may be implemented into a cuboidal case in which a hollow space is provided. However, a shape and a size of the housing 40 may not be limited thereto, and may be changeable if needed.

According to an embodiment, the housing 40 may include spaces (not shown in the drawing) for distinguishing and receiving the battery modules 100-1 to 100-6, and the spaces in the housing 40 may be formed through a cell barrier (not shown in the drawing).

According to an embodiment, as shown in FIG. 8 and FIG. 9, the slave BMSs 200-1 to 200-6 may be installed on the substrate 41. The substrate 41 may be arranged on the upper surfaces of the battery modules 100-1 to 100-6 received in the housing 40, and may be made of an insulator.

The slave BMSs 200-1 to 200-6 installed on the substrate 41 may correspond to the battery modules 100-1 to 100-6, and may be electrically connected to the battery modules 100-1 to 100-6.

FIG. 8 shows that one substrate 41 is provided, the number of the substrates 41 is not limited thereto, and it may be changeable if needed. For example, the number of the substrate 41 may be implemented as being equal to the number of the slave BMSs 200-1 to 200-6, i.e., multiple ones, and the slave BMSs 200-1 to 200-6 may be arranged on each of the substrates 41.

According to an embodiment, the integrated distributor 420 and the connectors 430-1 to 430-6 may be arranged on the substrate 41 on which the slave BMSs 200-1 to 200-6 are installed. The integrated distributor 420 may be arranged on a portion, where the slave BMSs 200-1 to 200-6 are not arranged, on the substrate 41, and may be connected to wireless ports of the slave BMSs 200-1 to 200-6 through the connectors 430-1 to 430-6. The single antenna 410 may be implemented in a chip form installed in the substrate 41 or the integrated distributor 420.

FIG. 8 shows that the integrated distributor 420 and the single antenna 410 are arranged on the same substrate as the slave BMSs 200-1 to 200-6, the form of the substrate 41 on which the integrated distributor 420, the single antenna 410, and the slave BMSs 200-1 to 200-6 are arranged is not limited thereto, and it may be changeable if needed. For example, multiple substrates 41 may be implemented, and the integrated distributor 420, the single antenna 410, and the slave BMSs 200-1 to 200-6 may be arranged on the substrates 41. That is, the integrated distributor 420, the single antenna 410, and the slave BMSs 200-1 to 200-6 may be arranged on the different substrates.

According to an embodiment, the slave BMSs 200-1 to 200-6 may be arranged on the battery modules 100-1 to 100-6. The single antenna 410 may be arranged on one of the battery modules 100-1 to 100-6. According to an embodiment, the one battery module on which the single antenna 410 is arranged may be disposed in the middle of the battery modules 100-1 to 100-6.

FIG. 8 and FIG. 9 exaggerates the components of the battery system 2 according to an embodiment, for better comprehension and ease of description.

For example, FIG. 8 shows an empty space is disposed between the battery modules 100-1 to 100-6 received in the housing 40, which is exaggerated for better comprehension and ease of description, the present disclosure is not limited thereto, and it may be changeable if needed. For example, a specific structure may be filled in the empty space between the battery modules 100-1 to 100-6, or the battery modules 100-1 to 100-6 may be received in the housing 40 so that there may be no empty space therebetween.

Also, FIG. 9 shows that there is an empty space between the upper surface of the housing 40 and the substrate 41, which is exaggerated for better understanding and ease of description, the present disclosure is not limited thereto, and it may be changeable if needed.

The range of the present disclosure is provided in the claims to be described rather than the above-described detailed description, and all modifications or modified forms drawn from the meanings, range, and equivalent concepts of the claims of the patent have to be interpreted to be included in the range of the present disclosure.

## Claims

1. A battery system for performing wireless communication comprising:
battery modules;
a single antenna;
slave BMSs connected to the battery modules, generating battery information by sensing states of the battery modules, and providing sensing signals including the battery information to the single antenna; and
a master BMS connected to an antenna, receiving the sensing signals transmitted through the single antenna through the antenna, obtaining the battery information according to the sensing signals, generating control signals for controlling the battery modules by using the obtained battery information, and transmitting the control signals to the single antenna through the antenna.

2. The battery system of claim 1, wherein
the battery information includes an information identifier indicating the slave BMS having generated specific battery information from among the slave BMSs.

3. The battery system of claim 1, wherein
the control signals include operation information for controlling an operation of at least one of the battery modules.

4. The battery system of claim 3, wherein
the operation information includes an instruction identifier for indicating a specific slave BMS from among the slave BMSs.

5. The battery system of claim 1, wherein
the master BMS wirelessly communicates with the slave BMSs by a frequency hopping method using an industrial scientific medical (ISM) bandwidth as a frequency bandwidth.

6. The battery system of claim 1, wherein
the master BMS designates a specific frequency bandwidth, selects hopping channels in the specific frequency bandwidth, and generates an arbitrary pattern using the selected hopping channel to perform wireless communication.

7. The battery system of claim 1, wherein
the battery system includes a substrate on which the slave BMSs and the single antenna are arranged, and
a housing into which the battery modules and the substrate are received and in which the master BMS is arranged.

8. The battery system of claim 1, wherein
the slave BMSs include
an integrated distributor for receiving the sensing signals, integrating the received sensing signals, and transmitting the integrated sensing signals through the single antenna, and
connectors for connecting nodes of the slave BMSs to the integrated distributor using a wire.

9. The battery system of claim 8, wherein
the integrated distributor recognizes the instruction identifier of the control signal received from the master BMS and transmits the control signal to a specific slave BMS from among the slave BMSs.

10. The battery system of claim 8, wherein
the integrated distributor transmits the control signal received from the master BMS to the slave BMSs through the connectors.

11. The battery system of claim 8, wherein
first ends of the connectors are connected to nodes of the slave BMSs, and second ends thereof are connected to the integrated distributor.

12. The battery system of claim 8, wherein
the connectors have the same length.

13. The battery system of claim 8, wherein
the battery system includes a substrate on which the slave BMSs, the single antenna, the integrated distributor, and the connectors are arranged, and
a housing into which the battery modules and the substrate are received and in which the master BMS is arranged.
